(19) Europäisches Patentamt
European Patent Office
Office européen des brevets

(11) **EP 3 487 268 A1**

(12) **EUROPEAN PATENT APPLICATION**
published in accordance with Art. 153(4) EPC

(43) Date of publication:
**22.05.2019 Bulletin 2019/21**

(21) Application number: **17827148.2**

(22) Date of filing: **06.02.2017**

(51) Int Cl.:
**H05K 1/02** *(2006.01)*     **H05K 1/09** *(2006.01)*

(86) International application number:
**PCT/JP2017/004183**

(87) International publication number:
**WO 2018/012013 (18.01.2018 Gazette 2018/03)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**MA MD**

(30) Priority: **12.07.2016 JP 2016137323**

(71) Applicant: **Fujikura, Ltd.**
**Tokyo 135-8512 (JP)**

(72) Inventors:
• **OGURA, Shingo**
**Sakura-shi**
**Chiba 285-8550 (JP)**
• **SUEMASU, Tatsuo**
**Sakura-shi**
**Chiba 285-8550 (JP)**
• **HIRANO, Hiroyuki**
**Sakura-shi**
**Chiba 285-8550 (JP)**
• **ISHII, Masaaki**
**Sakura-shi**
**Chiba 285-8550 (JP)**

(74) Representative: **Ter Meer Steinmeister & Partner**
**Patentanwälte mbB**
**Artur-Ladebeck-Strasse 51**
**33617 Bielefeld (DE)**

(54) **STRETCHABLE SUBSTRATE**

(57)     A stretchable board (10) includes a substrate (20) having a stretching property and a conductor portion (41) provided on the substrate (20). The conductor portion (41) includes conductor wires (411) intersecting with each other and an opening (415) formed by the conductor wires (411) in plan view.

Fig.3

EP 3 487 268 A1

**Description**

TECHNICAL FIELD

The present invention relates to a stretchable board.
For designated countries that are permitted to be incorporated by reference in the literature, the contents of Patent Application No. 2016-137323, filed with Japan Patent Office on July 12, 2016 is incorporated herein by reference and is regarded as a part of the description of this specification.

BACKGROUND ART

A circuit board in which a wiring wire has a corrugated zigzag pattern shape and which is stretchable in terms of shape has been known as a stretchable flexible circuit board (for example, see Patent Document 1).

CITATION LIST

PATENT DOCUMENT

Patent Document 1: JP 2013-187380 A

SUMMARY OF THE INVENTION

PROBLEM TO BE SOLVED BY THE INVENTION

In the above-described stretchable board, it is difficult to sufficiently suppress an increase in electric resistance value of the board due to stretching. For this reason, there is a problem that durability of the stretchable board with respect to stretching may be inferior.
A problem to be solved by the invention is to provide a stretchable board capable of improving durability with respect to stretching.

MEANS FOR SOLVING PROBLEM

[1] A stretchable board according to the invention includes a substrate having a stretching property, and a conductor portion provided on the substrate, in which the conductor portion includes conductor wires intersecting with each other, and an opening formed by the conductor wires in plan view.
[2] In the invention, a first imaginary straight line extending in a direction orthogonal to an extending direction of the conductor portion may intersect with at least two conductor wires in plan view.
[3] In the invention, the conductor portion may include the openings mutually having the same shape, and the openings may be repeatedly arranged along the extending direction of the conductor portion.
[4] In the invention, at least one of Expression (1) or Expression (2) below may be satisfied, and Expression (3) below may be satisfied:

$$W_1 \leq 100 \ \mu m \ \dots \ (1)$$

$$W_1/W_2 \leq 0.1 \ \dots \ (2)$$

$$2 \leq P_1/W_1 \leq 10 \ \dots \ (3)$$

Where, in the above Expressions (1) to (3), $W_1$ denotes a width of the conductor wire, $W_2$ denotes a width of the conductor portion, and $P_1$ denotes a pitch between adjacent conductor wires.
[5] In the invention, Expression (4) below may be satisfied:

$$0.2 \leq H/W_1 \leq 4 \ \dots \ (4)$$

where H denotes a height of the conductor wire in the above Expression (4).

[6] In the invention, the conductor wire may extend to be inclined with respect to the extending direction of the conductor portion.

[7] In the invention, Expression (5) below may be satisfied:

$$30° \leq \theta_1 < 90° \ \dots \ (5)$$

where $\theta_1$ denotes an angle between a second imaginary straight line along the extending direction of the conductor portion and a third imaginary straight line along an extending direction of the conductor wires in the above Expression (5).

[8] In the invention, Expression (6) below may be satisfied:

$$45° \leq \theta_1 \leq 75° \ \dots \ (6).$$

[9] In the invention, the conductor wire may contain a conductive material having a stretching property, and the conductive material may include a conductive particle and an elastomer.

[10] In the invention, the conductor wire may have a first surface facing the substrate, a second surface on an opposite side from the first surface, and a third surface interposed between the first surface and the second surface, a surface roughness of the first surface may be relatively larger than a surface roughness of the second surface, and the surface roughness of the first surface may be relatively larger than a surface roughness of the third surface.

[11] In the invention, the substrate may include a linear main surface in section view, and Expression (7) below may be satisfied:

$$90° \leq \theta_2 \leq 120° \ \dots \ (7)$$

where $\theta_2$ denotes an angle between a fourth imaginary straight line along the main surface and a fifth imaginary straight line along the third surface in the above Expression (7).

EFFECT OF THE INVENTION

According to the invention, an opening formed by a plurality of conductor wires is deformable by stretching. Accordingly, it is possible to improve durability of a stretchable board with respect to stretching.

BRIEF DESCRIPTION OF DRAWINGS

Fig. 1 is a perspective view illustrating a stretchable board for connecting external circuits to each other in an embodiment of the invention;
Fig. 2 is a plan view illustrating the stretchable board in the embodiment of the invention;
Fig. 3 is a partial enlarged view of a portion III of Fig. 2;
Fig. 4 is a plan view illustrating a first modification of the stretchable board in the embodiment of the invention;
Fig. 5 is a plan view illustrating a second modification of the stretchable board in the embodiment of the invention;
Fig. 6 is a cross-sectional view taken along VI-VI line of Fig. 3;
Fig. 7(A) to Fig. 7(E) are cross-sectional views illustrating a method of manufacturing the stretchable board in the embodiment of the invention;
Fig. 8 is a plan view for description of an operation of the stretchable board in the embodiment of the invention; and
Fig. 9 is a cross-sectional view illustrating a stretchable board in another embodiment of the invention.

MODE(S) FOR CARRYING OUT THE INVENTION

Hereinafter, embodiments of the invention will be described with reference to drawings.

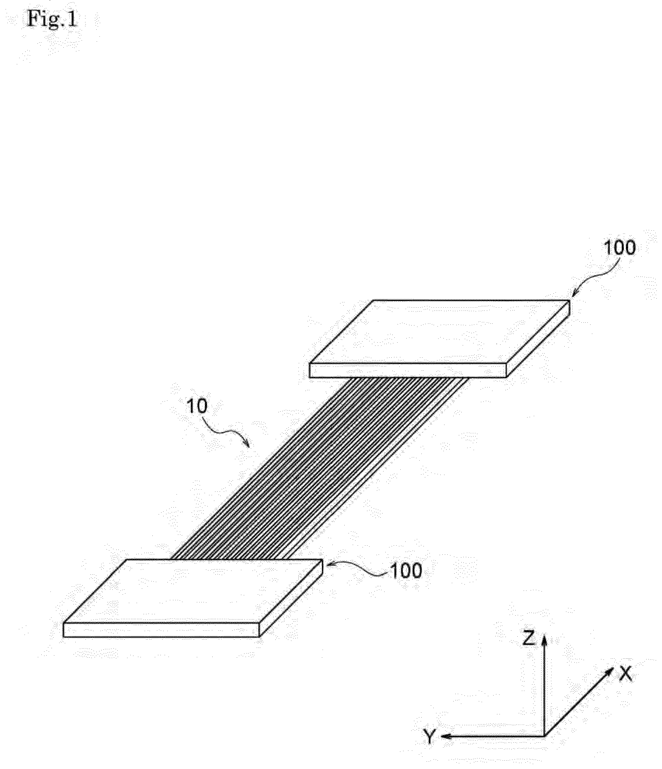

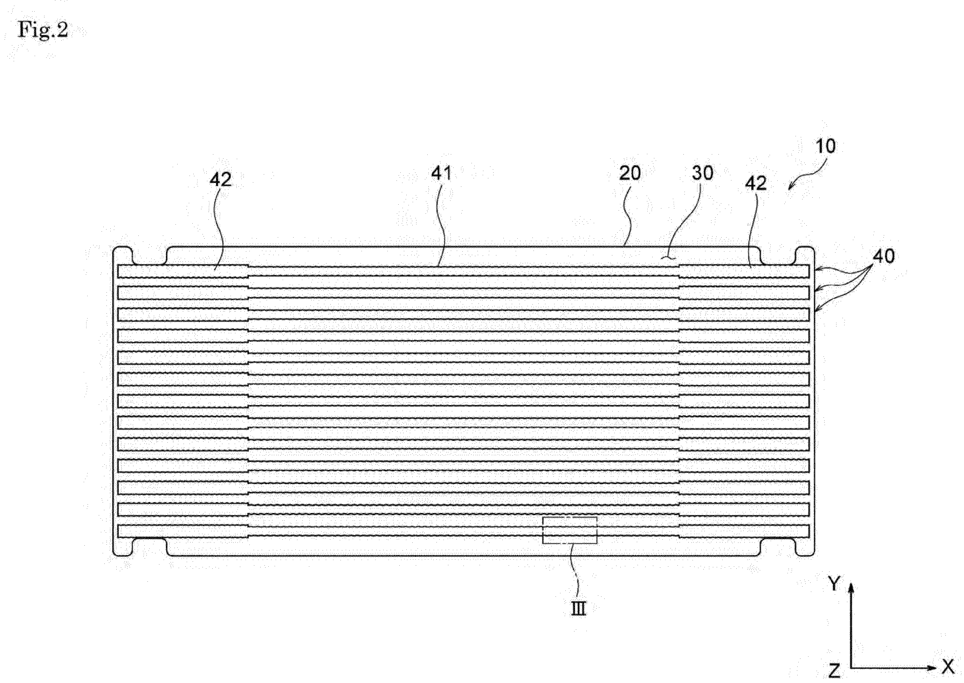

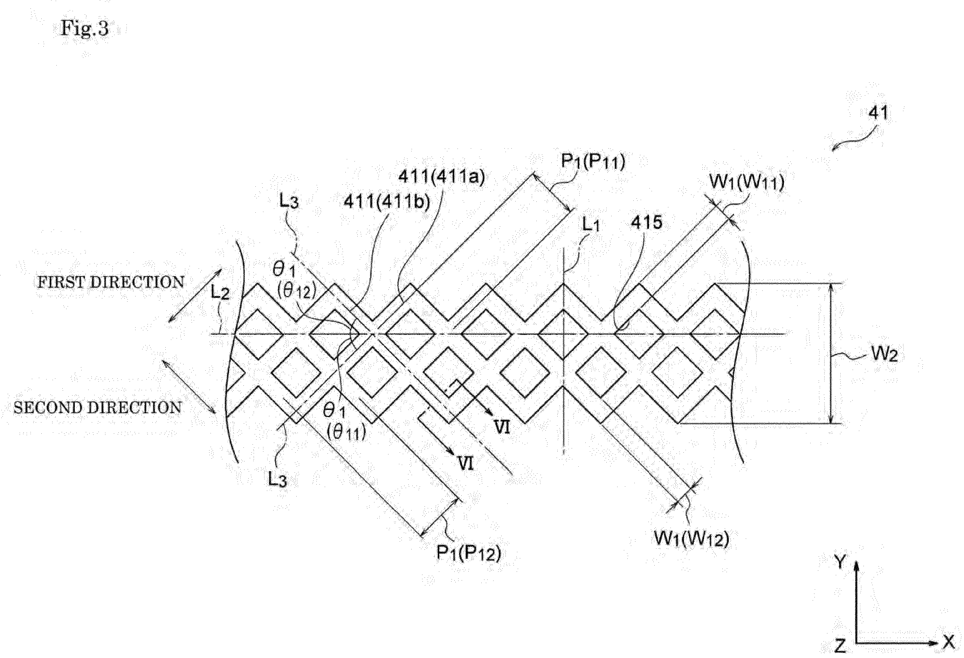

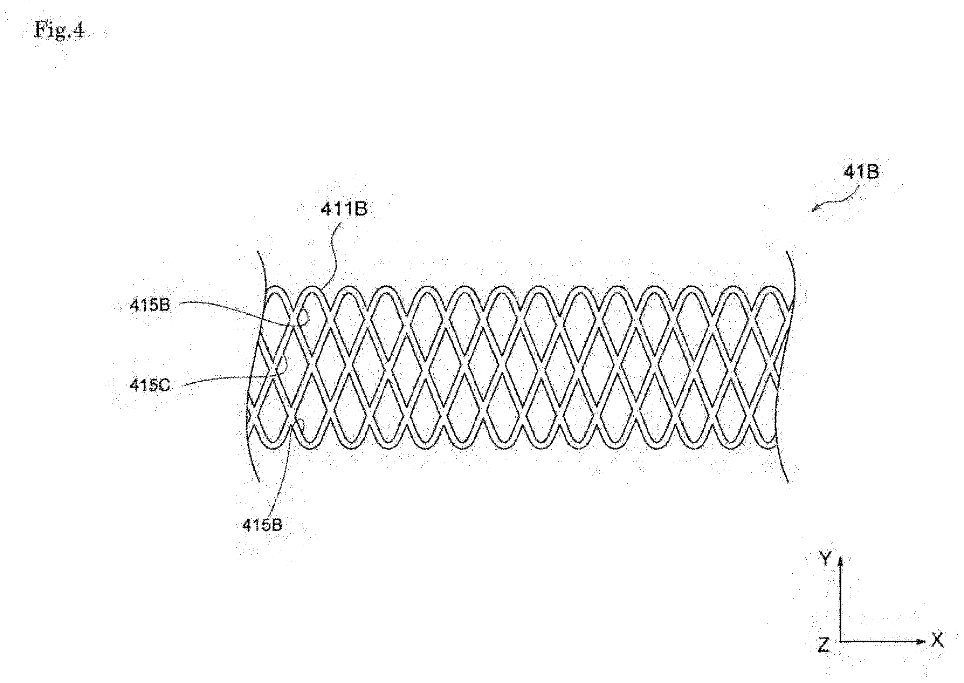

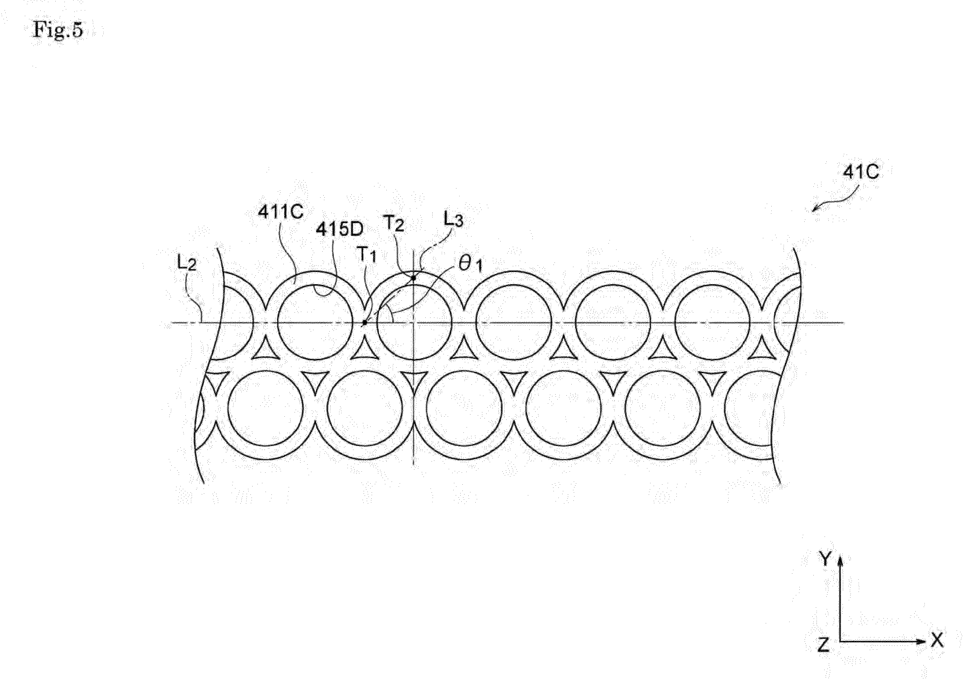

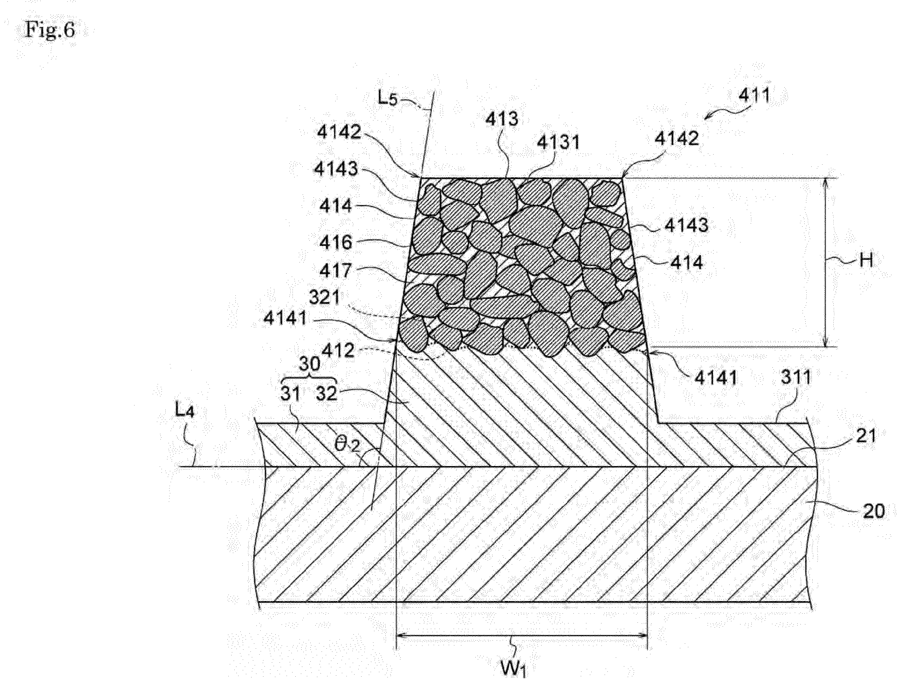

Fig. 1 is a perspective view illustrating a stretchable board for connecting external circuits to each other in an embodiment of the invention, Fig. 2 is a plan view illustrating the stretchable board in the embodiment of the invention, Fig. 3 is a partial enlarged view of a portion III of Fig. 2, Fig. 4 is a plan view illustrating a first modification of the stretchable board in the embodiment of the invention, Fig. 5 is a plan view illustrating a second modification of the stretchable board in the embodiment of the invention, and Fig. 6 is a cross-sectional view taken along VI-VI line of Fig. 3.

As illustrated in Fig. 1, for example, a stretchable board 10 in the present embodiment is a wiring board that electrically connects external circuits 100 such as a rigid board and a flexible printed circuit board (FPC) to each other. Although such a stretchable board 10 is not particularly limited, for example, the stretchable board 10 is particularly applied to a portion requiring expansion and contraction such as a movable portion/a bent portion of an industrial robot.

As illustrated in Fig. 2, Fig. 3, and Fig. 6, the stretchable board 10 includes a substrate 20, an adhesive portion 30 provided on the substrate 20, and a conductor portion 40 provided on the adhesive portion 30.

The substrate 20 is a plate-shaped member formed in a rectangular shape. A main surface 21 of the substrate 20 (the main surface 21 on an opposite side from a main surface in contact with the substrate 20 among main surfaces of the substrate 20) is a substantially flat surface formed in a linear shape in section view. The substrate 20 is made of a material having elasticity. Young's modulus of the material included in the substrate 20 is preferably 0.1 MPa to 100 MPa. As such a substrate 20, it is possible to use an elastic sheet obtained by shaping natural rubber, styrene butadiene rubber, butadiene rubber, chloroprene rubber, butyl rubber, nitrile rubber, ethylene propylene rubber, acrylic rubber, urethane rubber, silicone rubber, fluororubber, etc. into a sheet or a material obtained by shaping a resin material such as nylon, polyester, acrylic, or polyamide into a fiber or a woven fabric.

From a viewpoint of improving a stretching property of the stretchable board 10, it is preferable to set a thickness of the substrate 20 to be relatively small. Even though depending on a position to which the stretchable board 10 is applied, specifically, the thickness of the substrate 20 is preferably less than 1 mm, more preferably less than 0.3 mm, and even more preferably less than 0.1 mm.

The adhesive portion 30 is provided directly on the substrate 20. The adhesive portion 30 bonds the substrate 20 and the conductor portion 40 to each other. In addition, the adhesive portion 30 integrally holds the conductor portion 40 so that the conductor portion 40 is not separated.

As illustrated in Fig. 6, the adhesive portion 30 of the present embodiment includes a flat portion 31 and a protruding portion 32. The flat portion 31 is a portion of the adhesive portion 30 formed in the shape of a layer. An upper surface 311 of the flat portion 31 is a substantially flat surface having a linear shape in section view. A thickness of the flat portion 31 is preferably 5 $\mu$m to 100 $\mu$m.

The protruding portion 32 is integrally formed with the flat portion 31. This protruding portion 32 is provided to correspond to the conductor portion 40. The protruding portion 32 protrudes from the flat portion 31 in a direction away from the substrate 20.

An adhesive portion contact surface 321 of the protruding portion 32 in contact with the conductor portion 40 has an uneven shape which is complementary to an uneven shape of the conductor portion 40 in the case of viewing a cross section along a width direction of a conductor wire 411 (described below) of the conductor portion 40. In addition, also in the case of viewing a cross section along an extending direction of the conductor wire 411, this adhesive portion contact surface 321 has an uneven shape which is complementary to an uneven shape of the conductor portion 40. Note that, in order to describe the stretchable board 10 of the present embodiment so that the description is easy to understand, uneven shapes of the adhesive portion contact surface 321 and a conductor portion contact surface 412 are exaggerated in Fig. 6.

As such an adhesive portion 30, it is possible to use an elastic sheet obtained by shaping natural rubber, styrene butadiene rubber, butadiene rubber, chloroprene rubber, butyl rubber, nitrile rubber, ethylene propylene rubber, acrylic rubber, urethane rubber, silicone rubber, fluororubber, etc. into a sheet or a resin material such as nylon, polyester, acrylic, or polyamide.

The conductor portion 40 is provided directly on the adhesive portion 30. In the present embodiment, as illustrated in Fig. 2, thirteen conductor portions 40 extend along an X direction of the figure and are arranged in parallel in a Y direction of the figure. As long as adjacent conductor portions 40 are electrically insulated from each other, a pitch between the adjacent conductor portions 40 is not particularly limited.

As illustrated in Fig. 2, each of the conductor portions 40 includes a wiring portion 41 and a terminal portion 42. The wiring portion 41 and the terminal portion 42 are integrally formed. The term "integrally" means that members are not separated from each other and are formed as an integral structure by the same material (conductive particles having the same particle diameter, elastomer, etc.).

Rectangular terminal portions 42 are provided at both ends of each wiring portion 41 in a longitudinal direction. The terminal portions 42 are electrically connected to the external circuits 100, respectively. Note that, various shapes may be adopted as a shape of the terminal portion 42 according to a connection structure with the external circuit 100.

As illustrated in Fig. 3, the wiring portion 41 includes a plurality of conductor wires 411. The plurality of conductor wires 411 is arranged to cross each other. In this way, the wiring portion 41 is formed in a mesh shape.

More specifically, a conductor wire 411a linearly extends along a direction inclined by +45° with respect to the X direction (hereinafter also simply referred to as "first direction"), and a plurality of conductor wires 411a are arranged at an equal pitch $P_{11}$ in a direction substantially perpendicular to the first direction (hereinafter also simply referred to as "second direction"). Meanwhile, a conductor wire 411b linearly extends along the second direction, and a plurality of conductor wires 411b are arranged at an equal pitch $P_{12}$ in the first direction. Further, since these conductor wires 411a and 411b are orthogonal to each other, the mesh-shaped wiring portion 41 is formed. Note that, in this specification, a pitch refers to a center-to-center distance. The conductor wire 411 collectively refers to the above-described conductor wires 411a and 411b.

In the present embodiment, a first imaginary straight line $L_1$ extending in a width direction of the wiring portion 41 (a direction orthogonal to an extending direction of the wiring portion 41) intersects with at least two conductor wires 411 in plan view. For example, even when the first imaginary straight line $L_1$ is extended on intersection points of the plurality of conductor wires 411, the first imaginary straight line $L_1$ intersects with two conductor wires 411 (that is, the first imaginary straight line $L_1$ intersects with intersection points of two or more conductor wires 411).

Further, in the present embodiment, the conductor wire 411 extends to be inclined with respect to the extending direction of the wiring portion 41. More specifically, a third imaginary straight line $L_3$ along the extending direction of the conductor wire 411 extends to be inclined with respect to a second imaginary straight line $L_2$ along the extending direction of the wiring portion 41. For this reason, As compared with a case in which the conductor wire is extended in a direction parallel or perpendicular to the extending direction of the wiring portion, it is possible to attempt a reduction of an electric resistance value in the conductor portion 40 while attempting improvement of the stretching property of the stretchable board 10.

In this case, an angle $\theta_1$ between the second imaginary straight line $L_2$ along the extending direction of the wiring portion 41 and the third imaginary straight line $L_3$ along the extending direction of the conductor wire 411 is preferably set to satisfy Expression (8) below, and more preferably set to satisfy Expression (9) below. Note that, the angle $\theta_1$ is an angle that collectively refers to an angle $\theta_{11}$ between the second imaginary straight line $L_2$ and the third imaginary straight line $L_3$ along an extending direction of the conductor wire 411a and an angle $\theta_{12}$ between the second imaginary straight line $L_2$ and the third imaginary straight line $L_3$ along an extending direction of the conductor wire 411b.

$$30° \leq \theta_1 < 90° \ \dots \ (8)$$

$$45° \leq \theta_1 \leq 75° \ \dots \ (9)$$

Note that, when the conductor wire 411 is extended in a direction inclined by 45° with respect to the extending direction of the wiring portion 41 as in the present embodiment, the stretching property of the stretchable board 10 is hardly impaired not only in a case in which the stretchable board 10 is stretched along the extending direction (X direction) of the wiring portion 41 but also in a case in which the stretchable board 10 is stretched along the width direction (Y direction) of the wiring portion 41.

In addition, a width $W_1$ of the conductor wire 411 is preferably set to satisfy Expression (10) below. Note that, the width $W_1$ is a width that collectively refers to a width $W_{11}$ of the conductor wire 411a and a width $W_{12}$ of the conductor wire 411b.

$$W_1 \leq 100 \ \mu m \ \dots \ (10)$$

In addition, a relationship between the width $W_1$ of the conductor wire 411 and a width $W_2$ of the wiring portion 41 is preferably set to satisfy Expression (11) below, and more preferably set to satisfy Expression (12) below. Note that, in the present embodiment, in a case in which side ends of the wiring portion 41 are closed by the conductor wire 411, the width $W_2$ of the wiring portion 41 is a distance between intersection points of conductor wires 411 present at side ends on both sides of the wiring portion 41 (see Fig. 3). Although not illustrated, in a case in which the side ends of the wiring portion are not closed by the conductor wire, the width of the wiring portion is a distance between distal ends of the conductor wire protruding outward from intersection points of conductor wires present at outermost sides of the wiring portion.

$$W_1/W_2 \leq 0.1 \ldots (11)$$

$$0.01 \leq W_1/W_2 \leq 0.1 \ldots (12)$$

The wiring portion 41 of the present embodiment is preferably set such that at least one of the above Expressions (10) and (11) is satisfied and a relationship between the width $W_1$ of the conductor wire 411 and a pitch $P_1$ between adjacent conductor wires 411 satisfies Expression (13) below. Note that, the pitch $P_1$ is a pitch that collectively refers to the pitch $P_{11}$ between adjacent conductor wires 411a and the pitch $P_{12}$ between adjacent conductor wires 411b.

$$2 \leq P_1/W_1 \leq 10 \ldots (13)$$

Note that, a ratio $(P_1/W_1)$ of the pitch $P_1$ to the width $W_1$ is more preferably 5 to 10 ($5 \leq P_1/W_1 \leq 10$), and is even more preferably approximately 5 ($P_1/W_1 \approx 5$).

Note that, a configuration of the wiring portion 41 is not particularly limited to the above description. For example, although the pitch $P_{11}$ between the conductor wires 411a is substantially the same as the pitch $P_{12}$ between the conductor wires 411b ($P_{11} = P_{12}$) in the present embodiment, it is not particularly limited thereto. The pitch $P_{11}$ between the conductor wires 411a may be different from the pitch $P_{12}$ between the conductor wires 411b ($P_{11} \neq P_{12}$). Although the width $W_{11}$ of the conductor wire 411a is substantially the same as the width $W_{12}$ of the conductor wire 411b ($W_{11} = W_{12}$) in the present embodiment, it is not particularly limited thereto. The width $W_{11}$ of the conductor wire 411a may be different from the width $W_{12}$ of the conductor wire 411b ($W_{11} \neq W_{12}$).

The wiring portion 41 includes an opening 415 formed by causing a plurality of linear conductor wires 411 to intersect with each other. In the present embodiment, a plurality of rectangular (rhomboid) openings 415 is formed by the plurality of conductor wires 411 being orthogonal to each other. In the present embodiment, as the openings 415 are deformed in response to stretching of the stretchable board 10, the wiring portion 41 can follow stretching of the stretchable board 10.

The plurality of openings 415 mutually have the same shape. The plurality of openings 415 mutually having the same shape is repeatedly arranged along the extending direction (X direction) of the wiring portion 41. In the present embodiment, the plurality of openings 415 repeatedly arranged in the extending direction of the wiring portion 41 is arranged in parallel in two rows in the width direction (Y direction) of the wiring portion 41. All the plurality of openings 415 aligned in the two rows have the same shape, and all the openings 415 included in the wiring portion 41 have the same shape. Note that, the plurality of openings 415 mutually having the same shape may be arranged in parallel in three or more rows.

Note that, the shape of the opening 415 is not particularly limited to the above description. For example, it is possible to adopt a triangle such as an equilateral triangle, an isosceles triangle or a right triangle, or a quadrangle such as a parallelogram or a trapezoid. Alternatively, the shape of the opening 415 may be an n-polygon such as a hexagon, an octagon, a dodecagon or a decagon, a circle, an ellipse, or a star. In this way, a geometric pattern obtained by repeating various graphic units can be used as the shape of the opening 415.

Note that, the conductor wire 411 of the present embodiment has a linear shape. However, it is not particularly limited thereto, and it is possible to adopt a curved shape, a horseshoe shape, or a zigzag line shape. For example, in Fig. 4, the conductor wire 411B has a shape like a sinusoidal curve. In this case, a wiring portion 41B includes: a plurality of openings 415B formed at both side ends of the wiring portion 41B by the plurality of curved conductor wires 411B intersecting with each other and formed by a curved part and a linear part of the conductor wire 411B; and a plurality of openings 415C formed substantially at a center of the wiring portion 41B and formed in the shape of a rhomboid.

In an embodiment illustrated in Fig. 4, the plurality of openings 415B mutually having the same shape is repeatedly arranged along an extending direction of the wiring portion 41B. In addition, the plurality of openings 415C mutually having the same shape is also repeatedly arranged along the extending direction of the wiring portion 41B. In this case, it is possible to suppress stress concentration on an outermost side of the wiring portion 41B by giving a curvature to an inflection point of the conductor wire 411B on the outermost side of the wiring portion 41B.

In addition, as in an embodiment illustrated in Fig. 5, in a wiring portion 41C, in plan view, a plurality of substantially circular openings 415D formed by a plurality of conductor wires 411C and mutually having the same shape may be repeatedly arranged along an extending direction of the wiring portion 41C. In this case, an angle $\theta_1$ preferably satisfies the above Expression (8), and more preferably satisfies the above Expression (9). Note that, in this embodiment, a third imaginary straight line $L_3$ is set to an imaginary straight line passing through an intersection point $T_1$ and an intersection point $T_2$. The intersection point $T_1$ is an intersection point of a contour of an opening 415D and an imaginary straight line which passes through a center of the opening 415D and extends along the extending direction of the wiring portion 41C. The intersection point $T_2$ is an intersection point of a contour of an opening 415D and an imaginary straight line which passes through a center of the opening 415D and extends along a direction orthogonal to the extending direction of the wiring portion 41C.

Next, the conductor wire 411 of the present embodiment will be described in more detail.

As illustrated in Fig. 6, the conductor wire 411 of the present embodiment is made of a conductive material having a stretching property, and includes a conductive particle 416 and an elastomer 417. The conductive particle 416 is dispersed in the elastomer 417, and the elastomer 417 functions as a binder.

As such a conductive particle 416, it is possible to use a metal material made of a metal such as gold, silver, platinum, ruthenium, lead, tin, zinc or bismuth, an alloy thereof, or a nonmetallic material such as carbon. A shape of the conductive particle 416 preferably corresponds to a scaly or indefinite shape.

As the elastomer 417, it is possible to use acrylic rubber, urethane rubber, nitrile rubber, silicone rubber, fluororubber, etc. Note that, in the conductor wire 411, it is preferable that a ratio of a weight of the conductive particle 416 to a total weight of the conductor wire 411 is set to 75% to 95%.

Note that, in addition to the above-described materials, the conductor wire 411 may further contain an additive such as an antioxidant, a flame retardant, or a softener.

A thickness H of the conductor wire 411 is preferably 5 $\mu$m to 400 $\mu$m. Further, from a viewpoint of facilitating formation of the conductor wire 411 while ensuring conductivity, a ratio (aspect ratio) of the thickness H to a width $W_1$ of the conductor wire 411 is preferably set to satisfy Expression (14) below.

$$0.2 \leq H/W_1 \leq 4 \ \ldots \ (14)$$

The conductor wire 411 has the conductor portion contact surface 412, a conductor portion top surface 413, and two conductor portion side surfaces 414 in the case of viewing a cross section in a direction orthogonal to the extending direction thereof. The conductor portion contact surface 412 is a surface that faces the substrate 20 through the adhesive portion 30 and is in contact with the adhesive portion 30. The conductor portion contact surface 412 has an uneven shape. In the present embodiment, a part of the conductive particle 416 protrudes from the elastomer 417 on the conductor portion contact surface 412, whereby the conductor portion contact surface 412 has an uneven shape. The uneven shape of the conductor portion contact surface 412 is based on surface roughness of the conductor portion contact surface 412. Note that, a form of the conductor portion contact surface 412 is not particularly limited to the above description.

The conductor portion top surface 413 is a surface located on an opposite side from the conductor portion contact surface 412 in the conductor wire 411. This conductor portion top surface 413 includes a linear top surface flat portion 4131. In the present embodiment, the elastomer 417 enters between conductive particles 416 on the conductor portion top surface 413. For this reason, on the conductor portion top surface 413, the linear top surface flat portion 4131 is formed by exposed portions of slightly scattered conductive particles 416 and the elastomer 417 covering the conductive particles 416. Note that, a form of the top surface flat portion 4131 of the conductor portion top surface 413 is not particularly limited to the above description.

The top surface flat portion 4131 is a portion in which a part of half or more of a width of the conductor portion top surface 413 is continuously linear. In the present embodiment, the top surface flat portion 4131 is formed on the entire conductor portion top surface 413. A flatness of the top surface flat portion 4131 is 0.5 $\mu$m or less. Note that, the flatness can be defined by JIS (JIS B0621 (1984)).

The flatness of the top surface flat portion 4131 is obtained using a non-contact measuring method using laser light. Specifically, the flatness is measured by irradiating a measurement target (here, the conductor portion top surface 413) with band-like laser light and imaging reflected light on an imaging element (for example, two-dimensional CMOS). A method (maximum deviation type flatness) of setting planes passing through three points as far as possible, respectively, in a plane of the target and calculating a maximum value of deviations thereof as the flatness is used as a method of calculating the flatness. Note that, the measuring method and the calculating method of the flatness are not particularly limited to the above description. For example, the measuring method of the flatness may be a contact type measuring method using a dial gauge, etc. A method (maximum inclination type flatness) of calculating a value of a gap generated when the target plane is interposed between parallel planes as the flatness may be used as the calculating method of the flatness.

Each of the conductor portion side surfaces 414 is interposed between the conductor portion contact surface 412 and the conductor portion top surface 413. The conductor portion side surface 414 is connected to the conductor portion contact surface 412 at one end 4141 and is connected to the conductor portion top surface 413 at the other end 4142. The conductor portion side surface 414 and a side surface of the adhesive portion 30 are continuously connected to each other. In the present embodiment, two conductor portion side surfaces 414 and 414 of one conductor wire 411 are inclined to approach a center of the conductor wire 411 as being away from the substrate 20. In this case, the conductor wire 411 has a tapered shape a width of which is narrower as being away from the substrate 20 in the cross section width direction.

The conductor portion side surface 414 includes a linear side surface flat portion 4143. In the present embodiment, the elastomer 417 enters between the conductive particles 416 on the conductor portion side surface 414. For this reason, on the conductor portion side surface 414, the linear side surface flat portion 4143 is formed by exposed portions of slightly scattered conductive particles 416 and the elastomer 417 covering the conductive particles 416. Note that, a form of the side surface flat portion 4143 of the conductor portion side surface 414 is not particularly limited to the above description. Incidentally, since the conductive particles 416 are covered with the elastomer 417 on the conductor portion side surface 414, electric insulation between adjacent wiring portions 41 is improved, and occurrence of migration can be suppressed.

The side surface flat portion 4143 is a portion in which a part of half or more of a width of the conductor portion side surface 414 is continuously linear. In the present embodiment, the side surface flat portion 4143 is formed on the entire conductor portion side surface 414. A flatness of the side surface flat portion 4143 is 0.5 $\mu$m or more. The flatness of the side surface flat portion 4143 can be measured by the same method as that of measurement of the flatness of the top surface flat portion 4131 described above.

The conductor portion side surface 414 of the present embodiment is a linear inclined surface inclined to approach the center of the conductor wire 411 as being away from the substrate 20. However, it is not particularly limited thereto. For example, the conductor portion side surface 414 may be a curved surface formed in an arc shape protruding outward. In this way, in a case in which the width of the conductor wire 411 increases as being away from the substrate 20, it is preferable that the conductor portion side surface 414 is present on an outer side of the conductor wire 411 from a fifth imaginary straight line $L_5$ passing through the both ends 4141 and 4142 thereof (that is, it is preferable that the conductor portion side surface 414 does not have a flared shape).

In the present embodiment, from a viewpoint of suppressing occurrence of a locally disconnected state of the conductor wire 411 around the conductor portion top surface 413, it is preferable that an angle $\theta_2$ between a fourth imaginary straight line $L_4$ extending along the main surface 21 of the substrate 20 and the fifth imaginary straight line $L_5$ is set to satisfy Expression (15) below.

$$90° \leq \theta_2 \leq 120° \ \dots \ (15)$$

From a viewpoint of firmly bringing the adhesive portion 30 and the conductor portion 40 into close contact with each other, it is preferable that a surface roughness of the conductor portion contact surface 412 is relatively larger than a surface roughness of the conductor portion top surface 413. Specifically, it is preferable that while the surface roughness Ra of the conductor portion contact surface 412 is 0.1 $\mu$m to 3 $\mu$m, the surface roughness Ra of the conductor portion top surface 413 is 0.001 $\mu$m to 1.0 $\mu$m. Note that, the surface roughness Ra of the conductor portion contact surface 412 is more preferably 0.1 $\mu$m to 0.5 $\mu$m, and the surface roughness Ra of the conductor portion top surface 413 is more preferably 0.001 $\mu$m to 0.3 $\mu$m. A relationship of the surface roughness of the conductor portion top surface 413 with respect to the surface roughness of the conductor portion contact surface 412 is preferably 0.01 to less than 1, more preferably 0.1 to less than 1. Further, it is preferable that the surface roughness of the conductor portion top surface 413 is 1/5 or less of the width (maximum width) of the conductor wire 411. Note that, such surface roughness can be measured by the JIS method (JIS B0601 (revised March 21, 2013)). Measurement of the surface roughness of the conductor portion contact surface 412 and the surface roughness of the conductor portion top surface 413 may be performed along the width direction of the conductor wire 411 or may be performed along the extending direction of the conductor wire 411.

Incidentally, as described in the JIS method (JIS B0601 (revised March 21, 2013)), the "surface roughness Ra" here is "arithmetic average roughness Ra". The "arithmetic average roughness Ra" is a roughness parameter obtained by cutting off a long wavelength component (waviness component) from a sectional curve. Separation of the waviness component from the sectional curve is performed on the basis of a measurement condition (for example, a size of the object, etc.) necessary for determining a shape.

In addition, similarly to the conductor portion top surface 413, the surface roughness of the conductor portion contact surface 412 is relatively larger than the surface roughness of the conductor portion side surface 414. While the surface roughness Ra of the conductor portion contact surface 412 is 0.1 $\mu$m to 3 $\mu$m, the surface roughness Ra of the conductor portion side surface 414 is preferably 0.001 $\mu$m to 1.0 $\mu$m, more preferably 0.001 $\mu$m to 0.3 $\mu$m. Measurement of the surface roughness of the conductor portion side surface 414 may be performed along the width direction of the conductor wire 411 or may be performed along the extending direction of the conductor wire 411.

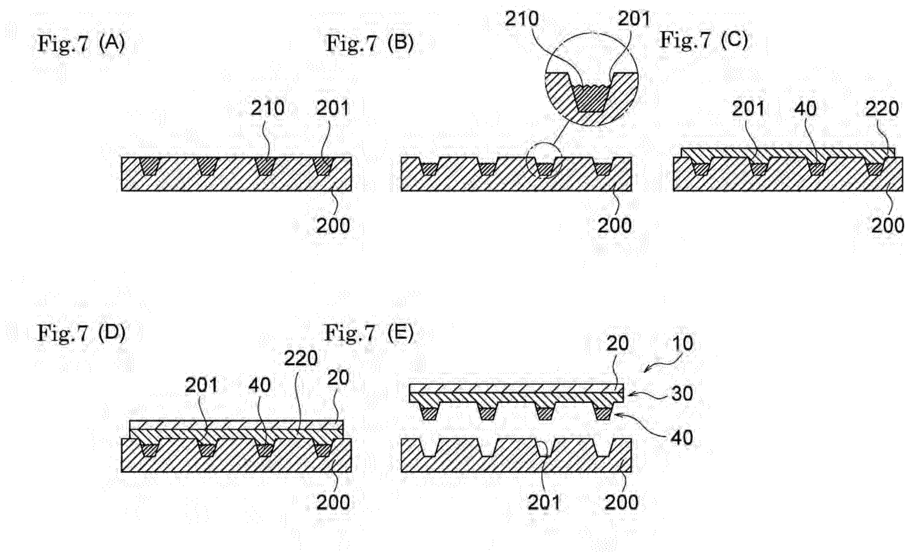

Next, a method of manufacturing the stretchable board 10 in the present embodiment will be described in detail with reference to Fig. 7(A) to Fig. 7(E).

Fig. 7(A) to Fig. 7(E) are cross-sectional views illustrating the method of manufacturing the stretchable board in the embodiment of the invention.

First, as illustrated in Fig. 7(A), an intaglio 200 in which a concave portion 201 having a shape corresponding to the shape of the conductor portion 40 is formed is prepared.

Examples of a material of which the intaglio 200 is made may include nickel, silicon, glasses such as silicon dioxide, ceramics, organic silica, glassy carbon, thermoplastic resin, and photocurable resin. A width and a depth of the concave portion 201 are set according to the width and the height of the conductor portion 40 to be formed. In the present embodiment, a cross-sectional shape of the concave portion 201 has a tapered shape that narrows toward a bottom. An inner wall surface of the concave portion 201 is a flat surface.

Note that, it is preferable to form a release layer (not illustrated) made of a graphite-based material, a silicone-based material, a fluorine-based material, a ceramic-based material, an aluminum-based material, etc. in advance on a surface of the concave portion 201 to improve a release property.

The concave portion 201 of the intaglio 200 is filled with a conductive material 210. A conductive paste obtained by mixing the conductive particles 416, the elastomer 417, water or a solvent, and various additives is used as such a conductive material 210. Examples of the solvent contained in the conductive paste may include $\alpha$-terpineol, butyl carbitol acetate, butyl carbitol, 1-decanol, butyl cellosolve, diethylene glycol monoethyl ether acetate, and tetradecane.

Examples of a method of filling the concave portion 201 of the intaglio 200 with the conductive material 210 may include a dispensing method, an inkjet method, and a screen printing method. Alternatively, the examples may include a method of wiping off, scraping off, sucking up, pasting and taking off, washing away, or blowing away the conductive material applied to a part other than the concave portion 201 after coating using a slit coating method, a bar coating method, a blade coating method, a dip coating method, a spray coating method, or a spin coating method.

Subsequently, as illustrated in Fig. 7(B), the conductor portion 40 is formed by heating the conductive material 210 filled in the concave portion 201 of the intaglio 200. A heating condition of the conductive material 210 can be appropriately set according to a composition of the conductive material, etc. By this heat treatment, the conductive material 210 shrinks in volume. In addition, a portion of the conductive material 210 not facing the concave portion 201 is formed in an uneven shape by being subjected to a heat treatment in a state exposed to the outside. On the other hand, a portion of the conductive material 210 facing the concave portion 201 is formed in a flat surface by transfer of the inner wall surface of the concave portion 201.

Note that, a method of treating the conductive material 210 is not limited to heating. It is possible to adopt irradiation with an energy ray such as an infrared ray, an ultraviolet ray or laser light or only drying. Alternatively, two or more of these treatment methods may be combined.

Subsequently, as illustrated in Fig. 7(C), an object obtained by substantially uniformly applying an adhesive material 220 for forming the adhesive portion 30 onto the substrate 20 is prepared. The material contained in the above-mentioned adhesive portion 30 is used as such an adhesive material 220. Examples of a method for applying the adhesive material 220 onto the substrate 20 may include a screen printing method, a spray coating method, a bar coating method, a dipping method, and an ink jet method.

Subsequently, as illustrated in Fig. 7(D), the substrate 20 and the adhesive material 220 are disposed on the intaglio 200 and the substrate 20 is pressed against the intaglio 200 so that the adhesive material 220 enters the concave portion 201 of the intaglio 200, and the adhesive material 220 is cured. Examples of a method of curing the adhesive material 220 may include irradiation with an energy ray such as an ultraviolet ray or infrared laser light, heating, heating and cooling, and drying. In this way, the adhesive portion 30 is formed. In addition, the substrate 20 and the conductor portion 40 are adhered to each other by the adhesive portion 30.

Note that, a method of forming the adhesive portion 30 is not particularly limited to the above description. For example, after applying the adhesive material 220 onto the intaglio 200 (the intaglio 200 in a state illustrated in Fig. 7 (B)) on which the conductor portion 40 is formed and disposing the substrate 20 on the adhesive material 220, the adhesive material 220 may be cured in a state in which the substrate 20 is disposed on the intaglio 200 and pressed, thereby forming the adhesive portion 30.

Subsequently, as illustrated in Fig. 7(E), the substrate 20, the adhesive portion 30, and the conductor portion 40 are released from the intaglio 200. In this way, the stretchable board 10 can be obtained.

The stretchable board 10 of the present embodiment has the following effects.

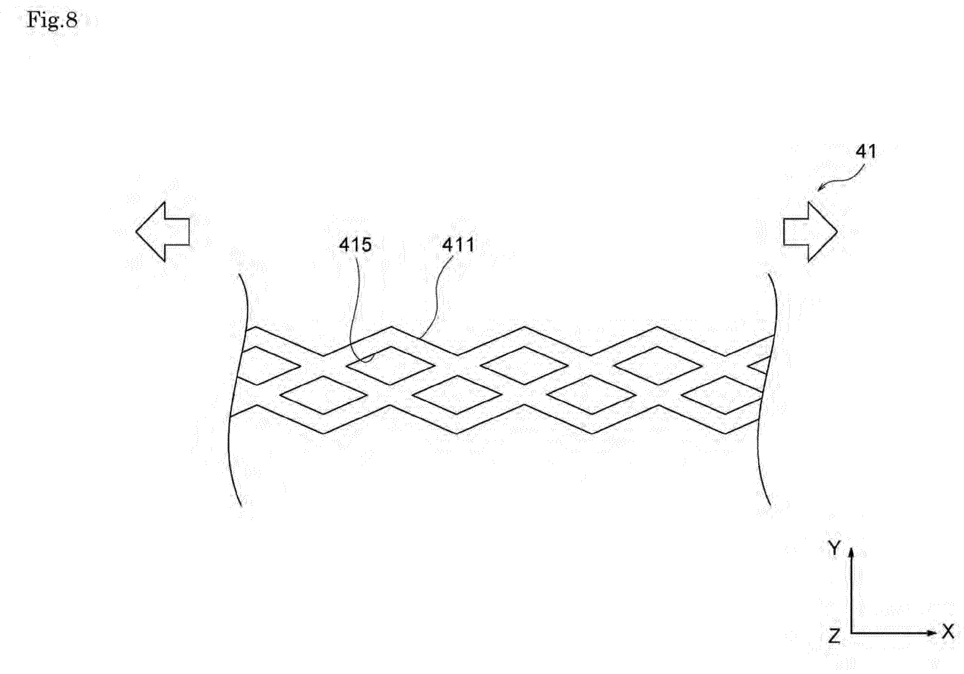

Fig. 8 is a plan view for description of an operation of the stretchable board in the embodiment of the invention.

In the wiring portion 41 of the present embodiment, the plurality of conductor wires 411 intersect with each other, and the openings 415 are formed by the plurality of conductor wires 411. In this case, as illustrated in Fig. 8, since the openings 415 can be deformed with respect to stretching of the wiring portion 41, stress applied to the wiring portion 41 is alleviated, and disconnection of the wiring portion 41 is unlikely to occur. For this reason, even when the wiring portion 41 stretches, an electric resistance value of the wiring portion 41 hardly changes. As a result, it is possible to improve durability of the stretchable board 10 against stretching.

In the present embodiment, in plan view, the first imaginary straight line $L_1$ extending in the direction orthogonal to the extending direction of the wiring portion 41 intersects with at least two or more conductor wires 411. For this reason, even when a crack or isolation is caused and breakage occurs in some of the conductor wires 411 due to stretching of the wiring portion 41, a conduction path in the entire wiring portion 41 is not lost since the other conductor wires 411 other than some of the conductor wires 411 in which the breakage, etc. occurs are present. In addition, since the plurality of conductor wires 411 is present in the extending direction of the wiring portion 41, even when some of the conductor wires 411 break, an increase in the electric resistance value of the entire wiring portion 41 is suppressed. In this way, even when the wiring portion 41 stretches, the electric resistance value of the wiring portion 41 hardly changes. As a result, it is possible to improve durability of the stretchable board 10 against stretching.

In the present embodiment, the wiring portion 41 includes the plurality of openings 415 mutually having the same shape, and the plurality of openings 415 is repeatedly arranged along the extending direction of the wiring portion 41. For this reason, since stress due to the stretching of the wiring portion 41 is uniformly applied to the entire wiring portion 41, local cracking and peeling of the conductor wire hardly occurs. In this way, even when the wiring portion 41 stretches, the electric resistance value of the wiring portion 41 hardly changes. As a result, it is possible to improve durability of the stretchable board 10 against stretching.

In the present embodiment, the conductor wire 411 extends to be inclined with respect to the extending direction of the wiring portion 41. For this reason, when the stretchable board 10 stretches in the extending direction of the wiring portion 41, in comparison with a case in which the conductor wire is extended in the direction parallel or perpendicular to the extending direction of the wiring portion, it is possible to suppress an increase in the electric resistance value of the entire wiring portion 41 while suppressing deterioration of the stretching property of the wiring portion 41. In particular, in a case in which the angle $\theta_1$ is set to satisfy the above Expression (8), the above effects can be more remarkably obtained. In a case in which the angle $\theta_1$ is set to satisfy the above Expression (9), the above effects can be even more remarkably obtained.

In the present embodiment, the wiring portion 41 is set to satisfy at least one of the above Expressions (10) and (11) and satisfy the above Expression (13). In this case, when at least one of the above Expressions (10) and (11) is satisfied, it is possible to suppress cracking and peeling from easily occurring in the conductor wire 411 due to the excessively small width $W_1$ of the conductor wire 411 while suppressing deterioration of the stretching property of the stretchable board 10 due to the excessively large width $W_1$ of the conductor wire 411. In addition, when the above Expression (13) is satisfied, it is possible to suppress cracking and peeling from easily occurring in the conductor wire 411 due to the excessively large pitch $P_1$ and stress concentration by stretching while suppressing deterioration of the stretching property of the stretchable board 10 due to the excessively small pitch $P_1$ between the adjacent conductor wires 411.

In the present embodiment, since the conductor wire 411 contains the conductive material having the stretching property, the conductor wire 411 can be deformed, so that the stress applied to the wiring portion 41 is alleviated, and disconnection of the wiring portion 41 is unlikely to occur. For this reason, even when the wiring portion 41 stretches, the electric resistance value of the wiring portion 41 hardly changes. As a result, it is possible to improve durability of the stretchable board 10 against stretching.

In the present embodiment, the surface roughness Ra of the conductor portion contact surface 412 of the conductor wire 411 is set to be relatively larger than the surface roughness Ra of the conductor portion top surface 413 and the conductor portion side surface 414. For this reason, the conductor portion 40 and the adhesive portion 30 are firmly adhered to each other, and it is possible to suppress falling of the conductor portion 40 from the substrate 20. In addition, in a case in which the stretchable board 10 is stretched, peeling of an interface between the conductor portion 40 and the adhesive portion 30 can be suppressed. In this way, mechanical strength of the stretchable board 10 can be improved.

In the present embodiment, the conductor wire 411 is set to satisfy the above Expression (15). For this reason, it is possible to suppress a case in which the width of the conductor portion top surface 413 of the conductor wire 411 is excessively small, the conductive particle 416 is not present around the conductor portion top surface 413, and thus a part around the conductor portion top surface 413 does not contribute to conduction of the wiring portion 41.

The "stretchable board 10" in the present embodiment corresponds to an example of a "stretchable board" in the invention, the "substrate 20" in the present embodiment corresponds to an example of a "substrate" in the invention, the "wiring portion 41" in the present embodiment corresponds to an example of a "conductor portion" in the invention, the "conductor wire 411" in the present embodiment corresponds to an example of a "conductor wire", the "opening 415" in the present embodiment corresponds to an example of an "opening" in the invention, the "conductive particle 416" in the present embodiment corresponds to an example of a "conductive particle" in the invention, the "elastomer 417" in the present embodiment corresponds to an example of an "elastomer" in the invention, the "conductor portion contact surface 412" in the present embodiment corresponds to an example of a "first surface" in the invention, the "conductor portion top surface 413" in the present embodiment corresponds to an example of a "second surface" in the invention, the "conductor portion side surface 414" in the present embodiment corresponds to an example of a "third surface" in the invention, the "main surface 21" in the present embodiment corresponds to an example of a "main surface" of the substrate in the invention, the "first imaginary straight line $L_1$" in the present embodiment corresponds to an example of a "first imaginary straight line" in the invention, the "second imaginary straight line $L_2$" in the present embodiment corresponds to an example of a "second imaginary straight line" in the invention, the "third imaginary straight line $L_3$" in the present embodiment corresponds to an example of a "third imaginary straight line" in the invention, the "fourth imaginary straight line $L_4$" in the present embodiment corresponds to an example of a "fourth imaginary straight line" in the invention, and the "fifth imaginary straight line $L_5$" in the present embodiment corresponds to an example of a "fifth imaginary straight line" in the invention.

Embodiments heretofore explained are described to facilitate understanding of the present invention and are not described to limit the present invention. It is therefore intended that the elements disclosed in the above embodiments include all design changes and equivalents to fall within the technical scope of the present invention.

For example, a cover lay (not illustrated) for protecting the conductor portion 40 may be further provided on the stretchable board 10 described in the above embodiment. Such a cover lay is formed to cover the conductor portion 40 except for the terminal portion 42 of the conductor portion 40. As a material of which such a cover lay is made, it is possible to use the same material as the material of which the substrate 20 is made or the same material as that of the elastomer 417.

For example, the conductor portion 40 may be made of a conductive material not having the stretching property. For example, the conductor portion may be made of copper wiring. Alternatively, it is possible to use a non-stretchable conductive paste.

In a case in which the conductor portion 40 contains the conductive material having the stretching property, the invention is not limited to a case in which the conductive particle 416 and the elastomer 417 are contained as in the above embodiment. For example, a conductive polymer such as polyacetylene may be used. Alternatively, instead of the conductive particle, a material in which a fibrous substance such as a silver nanowire or a carbon nanotube is contained in an elastomer may be used.

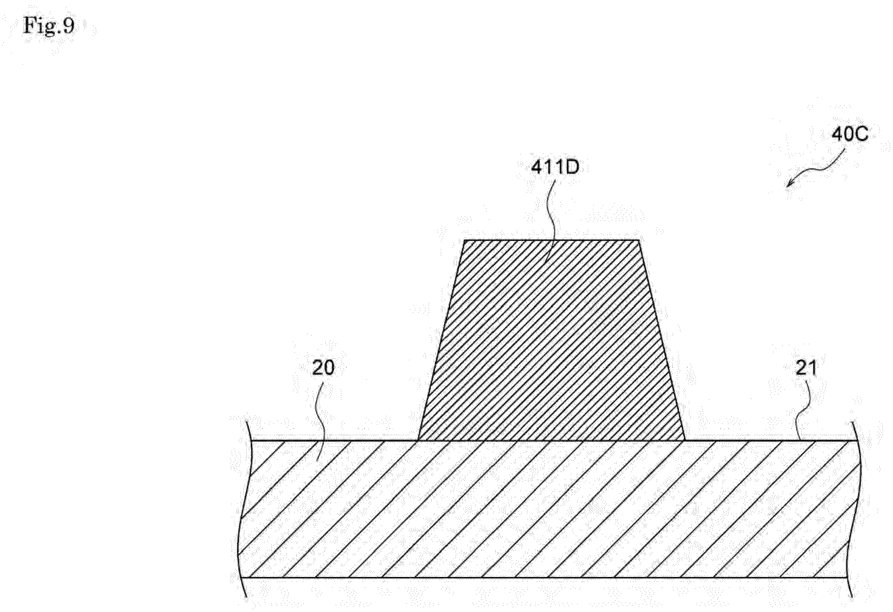

In the above embodiment, the adhesive portion 30 is interposed between the substrate 20 and the conductor portion 40. However, the invention is not particularly limited thereto. Fig. 9 is a cross-sectional view illustrating a stretchable board in another embodiment of the invention. In a stretchable board 10C illustrated in Fig. 9, a conductor portion 40C (conductor wire 411D) is directly formed on a main surface 21 of a substrate 20. Such a conductor portion 40C is formed by printing a conductive paste similar to the above-described conductive paste on the substrate 20 using a screen printing method, a dispensing method, an intaglio printing method, a letterpress printing method, an offset printing method, etc., and then curing the conductive paste through a curing treatment such as heating or electromagnetic wave irradiation.

In the above embodiment, the stretchable board 10 is used for electrically connecting the external circuits 100 to each other. However, it is not particularly limited to the above description. For example, although not particularly illustrated, the stretchable board may be a stretchable board including an electronic device such as an IC device or a thin film transistor (TFT) and a conductor portion on the same substrate. In this case, the conductor portion may be formed to electrically connect electric components mounted on the same substrate to each other.


EXAMPLES

Hereinafter, the invention will be described more specifically using Examples and Comparative Examples. The following Examples and Comparative Examples are used to verify durability of the stretchable board in the above-described embodiment.


<Example 1>

In Example 1, a silver paste (XA9424, manufactured by Fujikura Kasei Co., Ltd.) made of an elastomer and a conductive particle was prepared. Then, an intaglio was filled with a conductive paste and heated under a condition of about 150°C and 60 minutes, and the conductive paste was cured, thereby forming a conductor portion. The conductor portion was formed to mutually cross a plurality of conductor wires with each other and include a plurality of openings mutually having the same shape by these conductor wires. With regard to this conductor portion, a width $W_2$ of the conductor portion, a width $W_1$ and a thickness H of the conductor wires, a pitch $P_1$ between adjacent conductor wires, the number of intersection points of an imaginary straight line extending in a width direction of the conductor portion and the conductor wires (hereinafter also referred to as "a minimum number of conduction paths"), and an angle $\theta_1$ between an imaginary straight line along an extending direction of the conductor portion and an imaginary straight line along an extending direction of the conductor wires were set as shown in Table 1. Then, an adhesive material made of an elastomer (TB3164D manufactured by ThreeBond Co., Ltd.) was applied onto the intaglio, and a substrate (SRI manufactured by Fujikura Rubber Ltd.) made of an elastomer having width 1.5 mm × length 80 mm × thickness 0.1 mm was pressed against the intaglio while the adhesive material was interposed therebetween. In this state, an ultraviolet ray was irradiated under a condition of 3,000 mJ, and the adhesive material was cured, thereby forming an adhesive portion having a thickness of 10 $\mu$m. Thereafter, the substrate, the conductor portion, and the adhesive portion were released from the intaglio to obtain a test sample. The following test was conducted using the test sample.

«Stretching endurance test»

The test sample was stretched at a speed of 30 mm/min at room temperature while holding both longitudinal ends of the test sample at a holding interval of 50 mm. In this case, an electric resistance value between holding portions at both longitudinal ends of the conductor portion was measured, and an elongation rate of the test sample when the electric resistance value became twice of an initial electric resistance of the test sample was measured. A result is shown in Table 1 as a ratio with respect to a measured value in Comparative Example 1 described below.

<Examples 2 to 6>

In Examples 2 to 6, test samples were manufactured similarly to the test sample according to Example 1 except that a width $W_2$ of a conductor portion, a width $W_1$ and a thickness H of conductor wires, a pitch $P_1$ between adjacent conductor wires, a minimum number of conduction paths, and an angle $\theta_1$ between an imaginary straight line along an extending direction of the conductor portion and an imaginary straight line along an extending direction of the conductor wires were set as shown in Table 1.
With regard to these test samples, a stretching endurance tests were conducted similarly to Example 1. Results are shown in Table 1 as a ratio with respect to the measured value in Comparative Example 1 described below.

<Comparative Example 1>

In Comparative Example 1, a test sample was manufactured similarly to the test sample according to Example 1 except that a conductor portion was shaped in the form of a solid pattern having width 1,000 $\mu$m $\times$ thickness 40 $\mu$m was formed.
With regard to this test sample, a stretching endurance test was conducted similarly to Example 1. A result is shown in Table 1 as a reference value.
In addition, a test below was conducted using the test samples according to Examples 3 to 6 and Comparative Example 1.

«Repeated endurance test»

Both longitudinal ends of each of the test samples was held such that a holding interval corresponds to 50 mm, and the test sample was repeatedly stretched at 10% relative to a total length of the test sample at a speed of 500 mm/min at a rate of 30 times/min at room temperature. In this case, an electric resistance value between holding portions at both longitudinal ends of the conductor portion was measured, and the number of times of repeated stretching of the test sample when the electric resistance value became twice of an initial electric resistance of the test sample was measured. Results are shown in Table 1 as ratios with respect to the measured value in Comparative Example 1.

[Table 1]

Table 1

| | Width $W_2$ [μm] | Width $W_1$ [μm] | Pitch $P_1$ [μm] | Thickness H [μm] | Minimum number of conduction paths [number] | Angle $\theta_1$ [degree] | $W_1/W_2$ | $P_1/W_1$ | $H/W_1$ | Elongation rate [times] | Repeated stretching [times] |
|---|---|---|---|---|---|---|---|---|---|---|---|
| Example 1 | 1000 | 10 | 50 | 40 | 13 | 45 | 0.01 | 5 | 4 | 1.8 | |
| Example 2 | 1000 | 10 | 100 | 40 | 6 | 45 | 0.01 | 10 | 4 | 2.2 | |
| Example 3 | 1000 | 50 | 100 | 40 | 7 | 45 | 0.05 | 2 | 0.8 | 1.2 | 2.6 |
| Example 4 | 1000 | 50 | 250 | 40 | 3 | 45 | 0.05 | 5 | 0.8 | 2.0 | 37.1 |
| Example 5 | 1000 | 50 | 500 | 40 | 1 | 45 | 0.05 | 10 | 0.8 | 2.1 | 12.1 |
| Example 6 | 1000 | 100 | 500 | 40 | 1 | 45 | 0.1 | 5 | 0.4 | 1.8 | 21.5 |
| Comparative Example 1 | 1000 | - | - | 40 | - | - | - | - | - | 1.0 | 1.0 |

<Evaluation of Examples 1 to 6 and Comparative Example 1>

As shown in Table 1, in Examples 1 to 6 in which the conductor portion was formed to mutually cross the plurality of conductor wires with each other and include the plurality of openings by these conductor wires, in comparison with Comparative Example 1 in which the conductor portion was shaped in the form of the solid pattern, it is possible to confirm that a high elongation rate is obtained and the electric resistance value of the conductor portion hardly changes even when the conductor portion is stretched.

In particular, it is possible to confirm that the electric resistance value of the conductor portion hardly changes even when the conductor portion is stretched by setting a ratio ($W_1/W_2$) of the width $W_1$ to the width $W_2$ to satisfy the above Expression (11), setting a ratio ($P_1/W_1$) of the pitch $P_1$ to the width $W_1$ to satisfy the above Expression (13), and setting a ratio ($H/W_1$) of the thickness H to the width $W_1$ to satisfy the above Expression (14).

That is, from the results of Examples 1 to 6, it is possible to confirm that, even when the conductor portion stretches, the electric resistance value of the conductor portion hardly changes, and improvement of durability of the stretchable board with respect to stretching can be appropriately realized by forming the conductor portion to mutually cross the plurality of conductor wires with each other and include the plurality of openings by these conductor wires.

In addition, as shown in Table 1, in Examples 3 to 6 in which the conductor portion was formed to mutually cross the plurality of conductor wires with each other and include the plurality of openings by these conductor wires, in comparison with Comparative Example 1 in which the conductor portion was shaped in the form of the solid pattern, it is possible to confirm that the electric resistance value of the conductor portion hardly changes even when the conductor portion is repeatedly stretched.

In particular, from the results of Example 4 and Example 5, in a case in which the number of intersection points with the imaginary straight line orthogonal to the extending direction of the conductor portion is at least two or more (in a case in which the minimum number of conduction paths is two or more), it is possible to confirm that the electric resistance value of the conductor portion hardly changes even when the conductor portion is repeatedly stretched.

That is, from the results of Examples 3 to 6, it is possible to confirm that, even when the conductor portion is repeatedly stretched, the electric resistance value of the conductor portion hardly changes, and improvement of durability of the stretchable board with respect to repeated stretching can be appropriately realized by forming the conductor portion to mutually cross the plurality of conductor wires with each other and include the plurality of openings by these conductor wires.

<Examples 7 to 12>

In Examples 7 to 12, a width $W_2$ of a conductor portion, a width $W_1$ and a thickness H of conductor wires, a pitch $P_1$ between adjacent conductor wires, a minimum number of conduction paths, and an angle $\theta_1$ were set as shown in Table 2 to manufacture test samples similarly to the test sample according to Example 1.

With regard to the test samples according to Examples 7 to 12, the above-described stretching endurance tests were conducted. Results are shown in Table 2 as ratios with respect to a measured value in Comparative Example 2 described below. Note that, in the stretching endurance test, in a case in which a measured value of an elongation rate of a test sample according to an example is larger than 6.45 times a measured value of an elongation rate of a test sample according to Comparative Example 2, the value is greater than or equal to a measurement limit, and thus a result is set to above 6.45.

In addition, with regard to the test samples according to Examples 7 to 10, the above-described repeated stretching endurance tests were conducted. Results are shown in Table 2 as ratios with respect to a measured value in Comparative Example 2 described below. Note that, in the repeated stretching endurance test, when a measured value of the number of times of repeated stretching of a test sample according to an example is larger than 125 times a measured value of the number of times of repeated stretching of a test sample according to Comparative Example 2, the value is greater than or equal to a measurement limit, and thus a result is set to above 125.

<Comparative Example 2>

In Comparative Example 2, a test sample was manufactured similarly to the test sample according to Comparative Example 1.

With regard to this test sample, the stretching endurance test and the repeated endurance test described above were conducted. Results are shown in Table 2 as reference values.

Note that, a condition of a curing treatment of a conductive paste is mutually the same between the test samples according to Examples 7 to 12 and Comparative Example 2. However, a condition of a curing treatment of a conductive paste is different from the test samples according to Examples 1 to 6 and Comparative Example 1 described above. For this reason, between Example 4 and Example 8, even though a width $W_2$ of a conductor portion, a width $W_1$ and a

thickness H of conductor wires, a pitch $P_1$ between adjacent conductor wires, a minimum number of conduction paths, and an angle $\theta_1$ were the same values, results of the stretching endurance test and the repeated endurance test were different values.

[Table 2]

Table 2

| | Width $W_2$ | Width $W_1$ | Pitch $P_1$ | Thickness H | Minimum number of conduction paths | Angle $\theta_1$ | $W_1/W_2$ | $P_1/W_1$ | $H/W_1$ | Elongation rate | Repeated stretching |
|---|---|---|---|---|---|---|---|---|---|---|---|
| | [μm] | [μm] | [μm] | [μm] | [number] | [degree] | | | | [times] | [times] |
| Example 7 | 1000 | 50 | 300 | 40 | 3 | 30 | 0.05 | 6 | 0.8 | 0.9 | 2.3 |
| Example 8 | 1000 | 50 | 250 | 40 | 3 | 45 | 0.05 | 5 | 0.8 | 2.4 | >125 |
| Example 9 | 1000 | 50 | 300 | 40 | 2 | 60 | 0.05 | 6 | 0.8 | 5.4 | >125 |
| Example 10 | 1000 | 50 | 500 | 40 | 1 | 75 | 0.05 | 10 | 0.8 | >6.45 | >125 |
| Example 11 | 1000 | 50 | 250 | 10 | 3 | 45 | 0.05 | 5 | 0.2 | | 6.5 |
| Example 12 | 1000 | 50 | 250 | 20 | 3 | 45 | 0.05 | 5 | 0.4 | | 10.9 |
| Comparative Example 2 | 1000 | - | - | 40 | - | - | - | - | - | 1.0 | 1.0 |

<Evaluation of Examples 7 to 12 and Comparative Example 2>

As shown in Table 2, in Examples 7 to 10 in which the angle $\theta_1$ is set to satisfy the above Expression (8), in comparison with Comparative Example 2 in which the conductor portion was shaped in the form of the solid pattern, it is possible to confirm that the electric resistance value of the conductor portion hardly changes even when the conductor portion is repeatedly stretched.

In particular, from the results of Examples 8 to 10, in a case in which the angle $\theta_1$ is set to satisfy the above Expression (9), in comparison with Comparative Example 2, a high elongation rate is obtained and it is possible to confirm that the electric resistance value of the conductor portion hardly changes even when the conductor portion is stretched. In addition, from the results of Examples 8 to 10, in a case in which the angle $\theta_1$ is set to satisfy the above Expression (9), in comparison with Comparative Example 2, it is possible to confirm that the electric resistance value of the conductor portion extremely hardly changes even when the conductor portion is repeatedly stretched.

That is, from the results of Examples 7 to 10, it is possible to confirm that improvement of durability of the stretchable board with respect to stretching and improvement of durability of the stretchable board with respect to repeated stretching can be appropriately realized by setting the angle $\theta_1$ to satisfy the above Expression (8) or the above Expression (9).

In addition, as shown in Table 2, in Examples 11 and 12 in which the ratio ($H/W_1$) of the thickness H to the width $W_1$ of the conductor portion is set to satisfy the above Expression (14), in comparison with Comparative Example 2, it is possible to confirm that the electric resistance value of the conductor portion hardly changes even when the conductor portion is repeatedly stretched.

That is, from the results of Examples 11 and 12, it is possible to confirm that improvement of durability of the stretchable board with respect to repeated stretching can be appropriately realized by setting the ratio ($H/W_1$) of the thickness H to the width $W_1$ of the conductor portion to satisfy the above Expression (14).

EXPLANATIONS OF LETTERS OR NUMERALS

| | |
|---|---|
| 10 | STRETCHABLE BOARD |
| 20 | SUBSTRATE |
| 21 | MAIN SURFACE |
| 30 | ADHESIVE PORTION |
| 31 | FLAT PORTION |
| 311 | UPPER SURFACE |
| 32 | PROTRUDING PORTION |
| 321 | ADHESIVE PORTION CONTACT SURFACE |
| 40 | CONDUCTOR PORTION |
| 41 | WIRING PORTION |
| 411 | CONDUCTOR WIRE |
| 412 | CONDUCTOR PORTION CONTACT SURFACE |
| 413 | CONDUCTOR PORTION TOP SURFACE |
| 4131 | TOP SURFACE FLAT PORTION |
| 414 | CONDUCTOR PORTION SIDE SURFACE |
| 4141, 4142 | END |
| 4143 | SIDE SURFACE FLAT PORTION |
| 415 | OPENING |
| 416 | CONDUCTIVE PARTICLE |
| 417 | ELASTOMER |
| 42 | TERMINAL PORTION |
| 100 | EXTERNAL CIRCUIT |
| 200 | INTAGLIO |
| 201 | CONCAVE PORTION |
| 210 | CONDUCTIVE MATERIAL |
| 220 | ADHESIVE MATERIAL |

**Claims**

1.  A stretchable board comprising:

    a substrate having a stretching property; and
    a conductor portion provided on the substrate, wherein
    the conductor portion includes:

    conductor wires intersecting with each other; and
    an opening formed by the conductor wires in plan view.

2.  The stretchable board according to claim 1, wherein
    a first imaginary straight line extending in a direction orthogonal to an extending direction of the conductor portion intersects with at least two conductor wires in plan view.

3.  The stretchable board according to claim 1 or 2, wherein
    the conductor portion includes the openings mutually having the same shape, and
    the openings are repeatedly arranged along the extending direction of the conductor portion.

4.  The stretchable board according to any one of claims 1 to 3, wherein
    at least one of Expression (1) or Expression (2) below is satisfied, and Expression (3) below is satisfied:

$$W_1 \leq 100 \ \mu m \ \ldots \ (1)$$

$$W_1/W_2 \leq 0.1 \ \ldots \ (2)$$

$$2 \leq P_1/W_1 \leq 10 \ \ldots \ (3)$$

    where, in the above Expressions (1) to (3), $W_1$ denotes a width of the conductor wire, $W_2$ denotes a width of the conductor portion, and $P_1$ denotes a pitch between adjacent conductor wires.

5.  The stretchable board according to any one of claims 1 to 4, wherein Expression (4) below is satisfied:

$$0.2 \leq H/W_1 \leq 4 \ \ldots \ (4)$$

    where H denotes a height of the conductor wire in the above Expression (4).

6.  The stretchable board according to any one of claims 1 to 5, wherein
    the conductor wire extends to be inclined with respect to the extending direction of the conductor portion.

7.  The stretchable board according to claim 6, wherein
    Expression (5) below is satisfied:

$$30° \leq \theta_1 < 90° \ \ldots \ (5)$$

    where $\theta_1$ denotes an angle between a second imaginary straight line along the extending direction of the conductor portion and a third imaginary straight line along an extending direction of the conductor wires in the above Expression (5).

8.  The stretchable board according to claim 6 or 7, wherein
    Expression (6) below is satisfied:

$$45° \leq \theta_1 \leq 75° \ldots (6).$$

9. The stretchable board according to any one of claims 1 to 8, wherein
   the conductor wire contains a conductive material having a stretching property, and
   the conductive material includes a conductive particle and an elastomer.

10. The stretchable board according to any one of claims 1 to 9, wherein the conductor wire has:

    a first surface facing the substrate;
    a second surface on an opposite side from the first surface; and
    a third surface interposed between the first surface and the second surface,
    a surface roughness of the first surface is relatively larger than a surface roughness of the second surface, and
    the surface roughness of the first surface is relatively larger than a surface roughness of the third surface.

11. The stretchable board according to claim 10, wherein
    the substrate includes a linear main surface in section view, and Expression (7) below is satisfied:

$$90° \leq \theta_2 \leq 120° \ldots (7)$$

where $\theta_2$ denotes an angle between a fourth imaginary straight line along the main surface and a fifth imaginary straight line along the third surface in the above Expression (7).

Fig.1

Fig.2

EP 3 487 268 A1

Fig.3

Fig.4

EP 3 487 268 A1

Fig.5

Fig.6

EP 3 487 268 A1

Fig.7 (A)   Fig.7 (B)   Fig.7 (C)   Fig.7 (D)   Fig.7 (E)

Fig.8

EP 3 487 268 A1

Fig.9

EP 3 487 268 A1

## INTERNATIONAL SEARCH REPORT

| | International application No. |
|---|---|
| | PCT/JP2017/004183 |

**A. CLASSIFICATION OF SUBJECT MATTER**
*H05K1/02*(2006.01)i, *H05K1/09*(2006.01)i

According to International Patent Classification (IPC) or to both national classification and IPC

**B. FIELDS SEARCHED**

Minimum documentation searched (classification system followed by classification symbols)
H05K1/02, H05K1/09

Documentation searched other than minimum documentation to the extent that such documents are included in the fields searched
Jitsuyo Shinan Koho 1922–1996 Jitsuyo Shinan Toroku Koho 1996–2017
Kokai Jitsuyo Shinan Koho 1971–2017 Toroku Jitsuyo Shinan Koho 1994–2017

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X<br>Y<br>A | US 8332053 B1 (HRL LABORATORIES, LLC),<br>11 December 2012 (11.12.2012),<br>columns 1 to 4; fig. 1, 2<br>(Family: none) | 1-8<br>9<br>10,11 |
| Y<br>A | JP 2011-34822 A (Tokai Rubber Industries, Ltd.),<br>17 February 2011 (17.02.2011),<br>paragraphs [0001], [0034]<br>(Family: none) | 9<br>1-8,10,11 |

☒ Further documents are listed in the continuation of Box C. ☐ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 04 April 2017 (04.04.17) | 18 April 2017 (18.04.17) |

| Name and mailing address of the ISA/ | Authorized officer |
|---|---|
| Japan Patent Office<br>3-4-3,Kasumigaseki,Chiyoda-ku,<br>Tokyo 100-8915,Japan | |
| | Telephone No. |

Form PCT/ISA/210 (second sheet) (January 2015)

**INTERNATIONAL SEARCH REPORT**

International application No.

PCT/JP2017/004183

C (Continuation). DOCUMENTS CONSIDERED TO BE RELEVANT

| Category* | Citation of document, with indication, where appropriate, of the relevant passages | Relevant to claim No. |
|---|---|---|
| A | JP 2015-97290 A (MC10, Inc.),<br>21 May 2015 (21.05.2015),<br>entire text<br>& WO 2010/056857 A2<br>entire text<br>& EP 2356680 B1 & CA 2780747 A1<br>& US 2013/0313713 A1 | 1-11 |
| A | JP 2013-187380 A (Nippon Mektron, Ltd.),<br>19 September 2013 (19.09.2013),<br>entire text<br>(Family: none) | 1-11 |
| P,A | JP 2016-152047 A (Samsung Display Co., Ltd.),<br>22 August 2016 (22.08.2016),<br>entire text<br>& US 2016/0239133 A1<br>entire text<br>& EP 3056967 A1 & KR 10-2016-0101315 A<br>& CN 105892741 A | 1-11 |

Form PCT/ISA/210 (continuation of second sheet) (January 2015)

**REFERENCES CITED IN THE DESCRIPTION**

**Patent documents cited in the description**

- JP 2016137323 A

- JP 2013187380 A